(19) Europäisches Patentamt
European Patent Office
Office européen des brevets

(11) Publication number: 0 406 006 A2

(12) EUROPEAN PATENT APPLICATION

(21) Application number: 90307143.9

(22) Date of filing: 29.06.90

(51) Int. Cl.[5]: H01L 39/12

(30) Priority: 30.06.89 JP 170305/89

(43) Date of publication of application:
02.01.91 Bulletin 91/01

(84) Designated Contracting States:
DE FR GB

(71) Applicant: SHARP KABUSHIKI KAISHA
22-22 Nagaike-cho Abeno-ku
Osaka 545(JP)

(72) Inventor: Taniguchi, Hiroshi
2-506 Nara High Town, 606-76 Sanzyou-cho
Nara-shi, Nara(JP)
Inventor: Nakajima, Yoshitharu
7-204 Aoyama
Nara-shim, Nara(JP)

(74) Representative: West, Alan Harry et al
R.G.C. Jenkins & Co. 26 Caxton Streeteet
London SW1H 0RJ(GB)

# (54) Oxide superconductor.

(57) An oxide superconductor has the general formula $L_{1-\alpha}M_{\alpha}Ba_2Cu_3O_{7-\delta}$, in which L is a 111a group element, M is a IIa group element, $\alpha$ has a value from 0.01 to 0.1 and $\delta$ has a value from 0 to 1.0. Preferably, L is yttrium and M is calcium and $\alpha$ is 0.05 and the material has a cubic crystal structure.

Fig. 1.

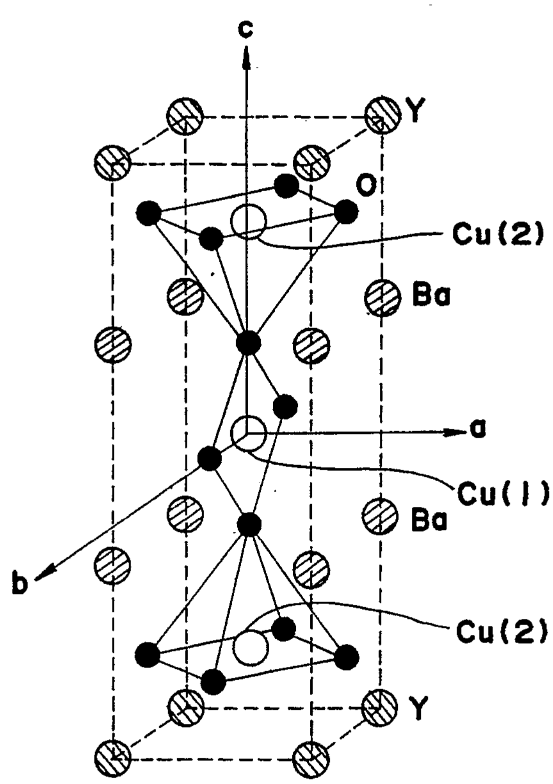


EP 0 406 006 A2

# OXIDE SUPERCONDUCTOR

The present invention relates to a Y-Ba-Cu-O oxide superconductor.

Recently, many oxide superconductors having high critical temperatures (Tc) were discovered. Among them, Y-Ba-Cu-O superconductor is excellent as a new electronic material because Tc is higher than the boiling point 77 K of liquid nitrogen and material of constant characteristics can be manufactured easily. Thus, Y-Ba-Cu-O superconductors have been used in many experiments and it is expected in future to be applied to various fields.

Further, it is known that, in ytterium oxide superconductors such as Y-Ba-Cu-O, ytterium can be replaced by other IIIa element or barium by other IIa element.

Superconducting characteristics of prior art ytterium oxides vary with composition ratio of oxygen. For example, $YBa_2Cu_3O_{7-\delta}$ has a Tc of about 90 K in the vicinity of $\delta$ = 0, while it has a Tc of about 60 K in the vicinity of $\delta$ = 0.5. Further, in the vicinity of $\delta$ = 1.0, it does not exhibit a superconducting property.

This is ascribable to the fact that holes as carriers of superconducting current are supplied by oxygens arranged along the b-axis of the Cu(1) site. Therefore, in order to manufacture a superconductor of high Tc, it is necessary to perform a heat treatment in a manufacturing process at 400 to 600 °C in an oxygen environment such as air or oxygen for a long time to increase the composition ratio of oxygen (see, for example, G. Fisher and M. Schober, Ceramic Bull, 88(1987) 1089, right column). However, such a heat treatment process to increase the oxygen ratio makes the manufacturing process complicated and the manufacturing time longer. Further, thereby, the vacuum is broken during a process for forming a thin film or the like, and this makes the application fields very limited.

It is an object of the present invention to provide a oxide superconductor which needs no heat treatment in the oxygen environment.

An oxide superconductor, according to the present invention, is of the formula $L_{1-\alpha}M_{\alpha}Ba_2Cu_3O_{7-\delta}$, wherein L is a IIIa group element, M is a IIa group element, $\alpha$ is in a range of 0.01 to 0.1 atomic percent and $\delta$ is in a range of 0 to 1.0.

Ytterium oxide superconductors which can be represented as $YBa_2Cu_3O_{7-\delta}$ are orthorhombic crystals at a room temperature, and have a layered Perovskite structure as shown in Fig. 1. In the structure, copper atoms exist at two different kinds of site. That is, Cu(1) forms a one-dimensional chain along the b-axis, while Cu(2) forms a two dimensional $CuO_2$ plane. It is known that conduction holes are provided by oxygen atoms arranged on the Cu(1) site.

On the other hand, in the oxide superconductor according to the present invention, conduction holes are supplied by replacing elements. For example, tri-valent ytterium is partially replaced by divalent calcium which has an ionic radius almost equal to trivalent ytterium to form Y-Ca-Ba-Cu-O. Due to the placement of the element, it becomes unnecessary to perform the heat treatment in the oxygen environment. Further, this enables to form a thin film as a superconductor in a vacuum and, therefore, various applications become possible. As to the replacement of ytterium (IIIa element) with calcium (IIa element), the repleacement of one to ten atomic percent is found to show good results.

Further objects and advantages of the present invention will be explained below with reference to the drawings, wherein

Fig. 1 is a diagram of the crystal structure of ytterium oxide superconductor;

Fig. 2 is a graph of the temperature dependence of electrical resistance of a ytterium oxide superconductor.

Fig. 3 is a chart of X rays powder diffraxion pattern of a ytterium oxide superconductor; and

Fig. 4 is a photoemission spectra chart of a ytterium oxide superconductor.

A ytterium oxide superconductor material represented by the general formula $Y_{1-\alpha}Ca_{\alpha}Ba_2Cu_3O_{7-\delta}$ is manufactured by using powders of $Y_2O$, $CaCO_3$, $BaCO_3$ and CuO. These raw materials are weighed as the ratio of the compound to be manufactured. Then, they are mixed, prefired, crushed, mixed again, and formed into pellets. Then, they are fired at 920 °C for eight hours in air.

As explained above, the heat treatment which is performed for a prior art ytterium oxide superconductor at 400 to 600 °C for a long time in order to control the oxygen content is not necessary for a ytterium oxide superconductor according to the present invention.

A ratio of ytterium to calcium of the oxide superconductor explained above is 0.95:0.05.

As shown in Fig. 2, the oxide superconductor manufactured as explained above show the superconducting transition wherein the resistance begins to decrease at about 90 K and becomes zero completely at 70 K.

The Meisner effect is not detected at the liquid nitrogen temperature for the oxide superconductor.

Fig. 3 shows a diffraction pattern obtained by CuK$\alpha$ X rays analysis with respect to the oxide superconductor powder manufactured as explained above. The abscissa designates 2$\theta$, while the ordinate shows the diffraction amplitude. This pattern shows that the oxide superconductor is a cubic crystal at a room temperature while the prior art Y-Ba-Cu-O oxide superconductors are orthorhombic crystals.

Further, Fig. 4 shows a photoelectronic spectra of Cu 2p inner shell electrons of an oxide superconductor manufactured as explained above. The abscissa and the ordinate designate the binding energy and the signal amplitude, respectively. Peaks designated by "A" and by "B" shows the electronic states of monovalent copper ions and of divalent copper ions, respectively.

The experimental results were analyzed numerically by using the Larsson-Sawatzky model to estimate the charge transfer between copper and oxygen and it was found to be about 1.4 eV.

In the above-mentioned embodiments, ytterium atoms are partially replaced by calcium ones. However, other IIIa elements such as Ce and/or Eu can also be used instead of ytterium. Further, other IIa elements such as strontium and/or magnesium barium can also be used instead of calcium. The amount of the replacement is not limited at five atomic percent, but at any amount within ten atomic percent.

The manufacturing method and the crystal structure of oxide superconductors according to the embodiment show that the heat treatment for the control of the oxygen ratio needed for prior art ytterium oxide superconductors is not needed completely or needed little. The improvement of the replacement ratio or the manufacturing method may produce oxide superconductors of better superconducting properties.

Thus, an oxide superconductor with high Tc can be manufactured without using a long-time postanneal in the oxygen environment. Further, a thin film of such an oxide superconductor can be manufactured in vacua or under a low pressure, so that the thin film can be combined with a semiconductor or a metal to form various kinds of electronic devices.

## Claims

1. An oxide superconductor having the general formula
$L_{1-\alpha} M_{\alpha}Ba_2 Cu_3 O_{7-\delta}$ in which
L is a IIIa group element;
M is a IIa group element;
$\alpha$ has a value from 0.01 to 0.1; and
$\delta$ has a value from 0 to 1.0.

2. An oxide superconductor according to claim 1, wherein L is yttrium.

3. An oxide superconductor according to claim 1, wherein L is one of cerium and europium.

4. An oxide superconductor according to any one of claims 1 to 3, wherein M is calcium.

5. An oxide superconductor according to any one of claims 1 to 3, wherein M is one of strontium, barium and magnesium.

6. An oxide superconductor according to any one of claims 1 to 5, wherein $\alpha$ is 0.05.

7. An oxide superconductor according to any one of claims 1 to 6 having a cubic crystal structure.

Fig. 1

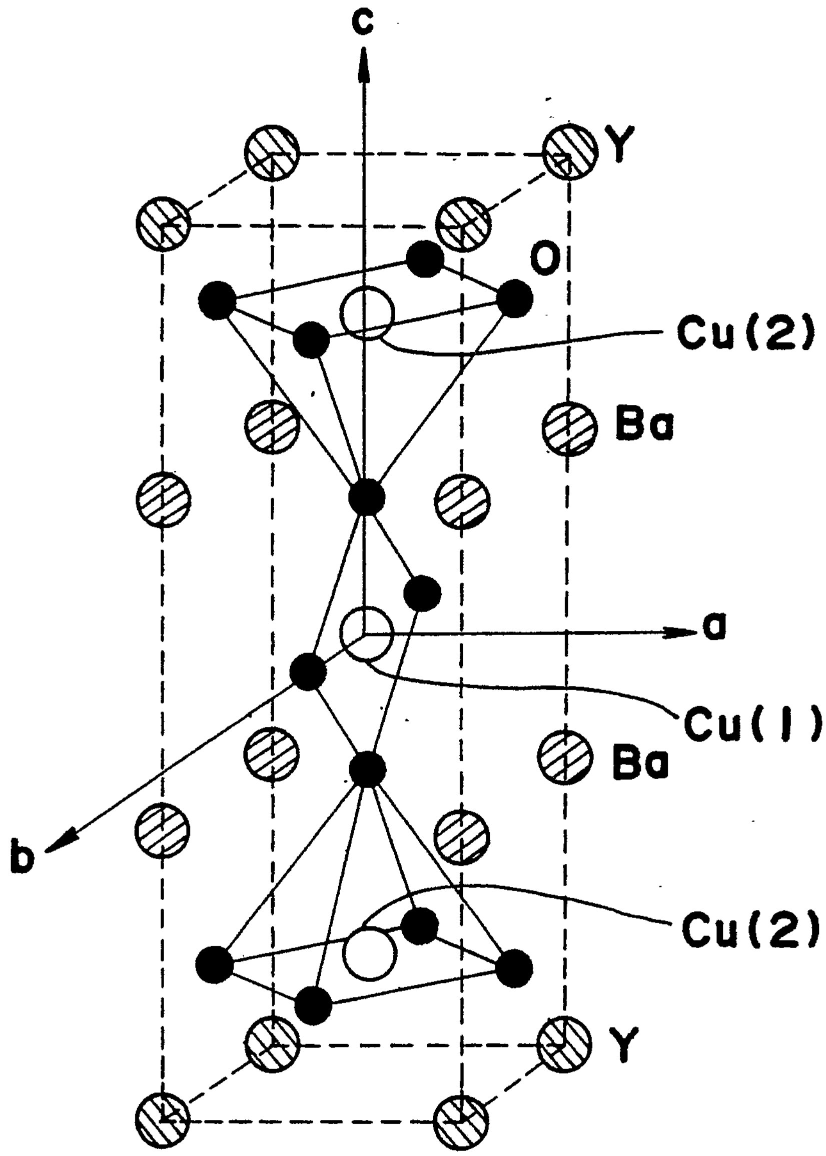

Fig. 2

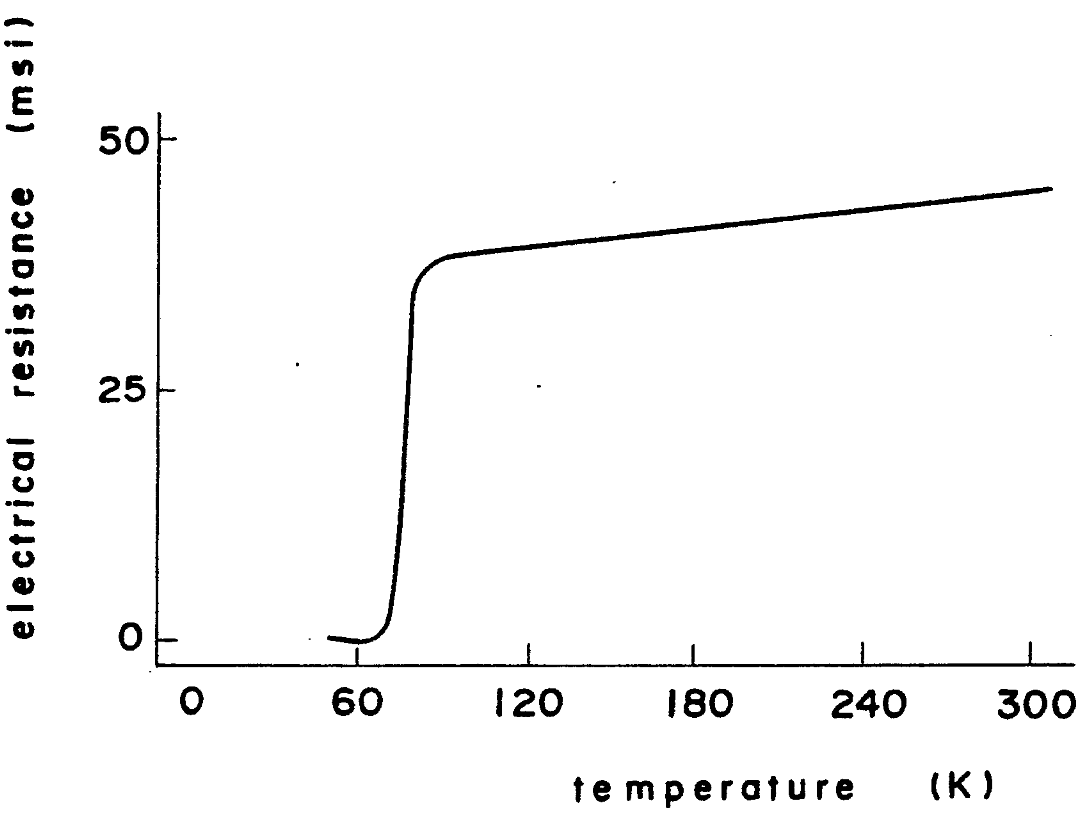
electrical resistance (msi)
50
25
0
0
60
120
180
240
300
temperature (K)

Fig. 3

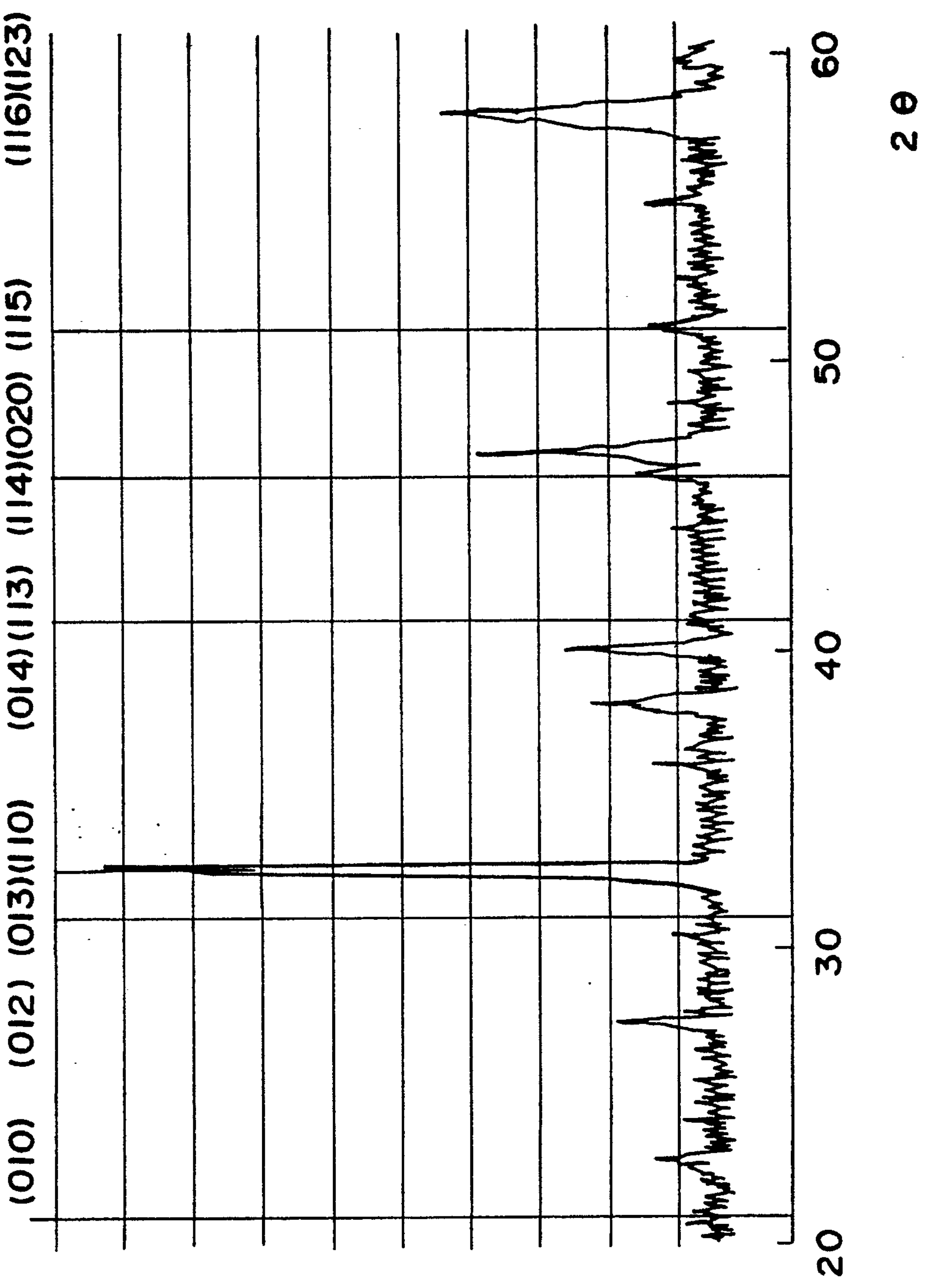

Fig. 4

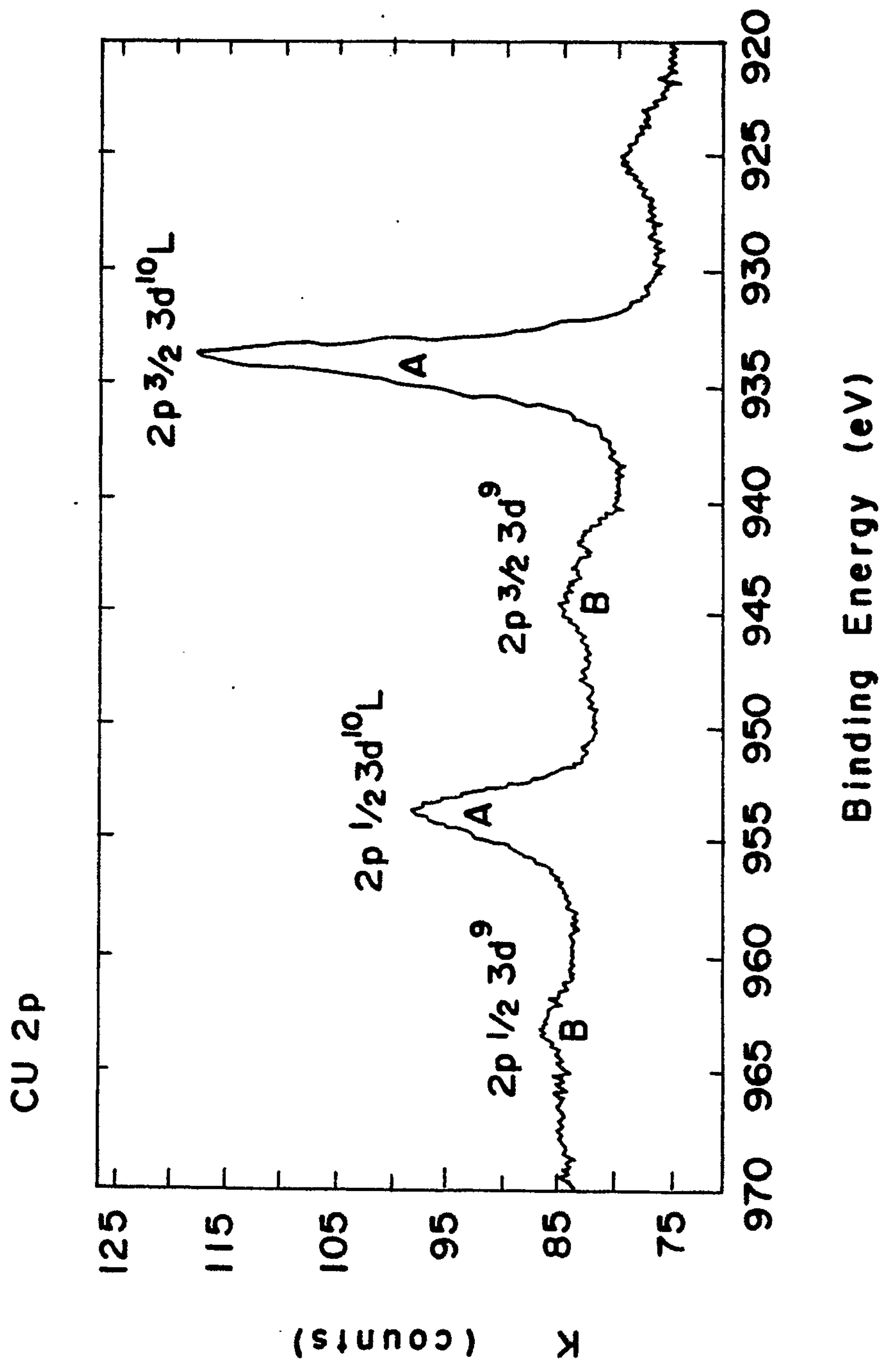
CU 2p
2p 3/2 3d10L
A
2p 3/2 3d9
B
2p 1/2 3d10L
A
2p 1/2 3d9
B
K (counts)
125
115
105
95
85
75
970
965
960
955
950
945
940
935
930
925
920
Binding Energy (eV)